# EUROPEAN PATENT APPLICATION

(11) **EP 4 712 165 A1**
(43) Date of publication of application: **18.03.2026**
(21) Application number: 24803634.5
(22) Date of filing: 30.04.2024
(51) Int. Cl.: H01M 4/48, H01M 4/587, H01M 4/36, H01M 4/134, C01B 33/02, H01M 4/02

(54) **SILICON-CARBON COMPOSITE FOR SECONDARY BATTERY NEGATIVE ELECTRODE MATERIAL, AND METHOD FOR PREPARING SAME**

(30) Priority: 08.05.2023 KR 20230059238; 26.12.2023 KR 20230191083
(71) Applicant: OCI Company Ltd., Seoul 04532 (KR)
(72) Inventor: CHO, Yongjae, Seongnam-si Gyeonggi-do 13212 (KR); CHANG, Joonhyun, Seongnam-si Gyeonggi-do 13212 (KR); KANG, Seung Yeon, Seongnam-si Gyeonggi-do 13212 (KR); NOH, Minho, Seongnam-si Gyeonggi-do 13212 (KR); LEE, Namjin, Seongnam-si Gyeonggi-do 13212 (KR); JEONG, Eunhye, Seongnam-si Gyeonggi-do 13212 (KR); CHI, Eunok, Seongnam-si Gyeonggi-do 13212 (KR)
(74) Representative: Zacco Sweden AB
(86) International application number: PCT/KR2024/005838
(87) International publication number: WO 2024/232580

(57) **Abstract**

The present invention relates to a silicon-carbon composite for a negative electrode material of a secondary battery and a method for manufacturing same and, more specifically, to a silicon-carbon composite for a negative electrode material of a secondary battery and a method for efficiently manufacturing the same, wherein when applied as a negative electrode material, the silicon-carbon composite for a negative electrode material of a secondary battery is capable of improving characteristics of a secondary battery by minimizing a volume change of silicon particles during charging and discharging processes of a secondary battery.

## Description

### FIELD

The present disclosure relates to a silicon-carbon composite for a negative-electrode material of a secondary battery and a method for preparing the same, and more particularly, to a silicon-carbon composite for a negative-electrode material of a secondary battery, which minimizes a change in volume of silicon particles during a charging/discharging process of the secondary battery so as to improve the characteristics of the secondary battery when being applied as the negative-electrode material, and a method for preparing the same in an efficient manner.

### DESCRIPTION OF RELATED ART

The performance improvement of the secondary battery is based on a positive-electrode material, a negative-electrode material, and electrolyte as components of thereof. A graphite-based material mainly used as the negative-electrode material among the above components is commercially available due to excellent electrochemical performance and low cost. However, since the theoretical capacity thereof is limited to 370 mAh/g, there is a limitation to application thereof to high-capacity secondary batteries.

In order to overcome the above limitation, a non-graphite-based negative-electrode material such as silicon, tin, and germanium has emerged as an alternative material thereto. Among them, silicon has a theoretical capacity of 4000 to 4200 mAh/g, may store therein a very large amount of lithium per unit weight, and exhibits a high capacity of almost 10 times or greater compared to the graphite, and thus has been spotlighted as a material for replacing the graphite. However, compared to the high theoretical capacity of silicon, a large volume expansion of about 400% of silicon occurs during the charging and discharging process, thereby causing problems such as silicon particles being broken and ground, reduction of electron conductivity with a carbon additive and the current collector, eventually leading to loss of capacity of the secondary battery and reduction of a cycle life thereof.

One of the methods for solving the above problem is using a silicon-carbon composite capable of suppressing the volume expansion of silicon particles with a carbon-based material. When the size of silicon particles inside the silicon-carbon composite is minimized, structural deformation of silicon particles during charging and discharging is fundamentally suppressed, thereby inducing additional performance improvement, and thus a high-performance negative-electrode material may be implemented.

A scheme for preparing the silicon-carbon composite includes a process of mainly pulverizing silicon into a silicon nanoparticle form, and then complexing the silicon particles with a carbon-based material so as to have an ideally known particle size (D50) of 1 *µ*m to 10 *µ*m.

However, this scheme requires a complicated preparing process, and has a disadvantage in that the limit particle diameter achieved by pulverizing silicon particles is 100 nm. In order to prepare silicon particles having a particle diameter smaller than 100 nm as the limit particle diameter achieved by pulverizing silicon particles, the silicon-carbon composite should be prepared using Chemical Vapor Deposition (CVD).

Referring to the related art of preparing a silicon-carbon composite using the chemical vapor deposition method, the silicon-carbon composite is prepared in a heterogeneous reaction manner using a substrate for deposition in order to have a composite particle size (D₅₀) of 1 *µ*m to 10 *µ*m.

Specifically, Korean Patent Application Publication No. 10-2021-0071246 ("Prior Art Document 1") and Korean Patent Application Publication No. 10-2020-0023870 ("Prior Art Document 2") mainly disclose a method for depositing a silicon layer on the substrate for deposition having a size of 1 to 10 *µ*m such that a combination of the silicon layer and the substrate is used as a negative-electrode active material.

In addition, Korean Patent Application Publication No. 10-2022-0087143 ("Prior Art Document 3") discloses depositing a composite in a form of a film on a huge substrate surface and then performing an additional pulverizing process to achieve a target particle size.

In the case of the techniques disclosed in Prior Art Documents 1 and 2, surface characteristics vary depending on the type of the substrate, such that there is a disadvantage in that complexity in which a process condition varies based on the type of the substrate is required.

In the case of the technique disclosed in Prior Art Document 3, a pulverization process is necessarily required, such that impurities are highly likely to be added to the silicon-carbon composite, and the sphericity of the final composite is low, and thus excessive formation of a solid-electrolyte interphase (SEI) layer may be caused when the silicon-carbon composite is applied as the negative-electrode material of the secondary battery, thereby leading to deterioration of the performance of the secondary battery.

Therefore, in order to implement a negative-electrode material (negative-electrode active material) having a high capacity retention rate, it is still necessary to develop a silicon-carbon composite capable of suppressing structural deformation of silicon particles during charging and discharging of a secondary battery and a method for preparing the same.

### [Prior Art Literature]

(Patent Document 1) Prior Art Document 1: Korean Patent Application Publication No. 10-2021-0071246
(Patent Document 2) Prior Art Document 2: Korean Patent Application Publication No. 10-2020-0023870
(Patent Document 3) Prior Art Document 3: Korean Patent Application Publication No. 10-2022-0087143

### DISCLOSURE

### TECHNICAL PURPOSE

A purpose of the present disclosure is to provide a silicon-carbon composite for a negative-electrode material for a secondary battery, which may improve initial discharge capacity, initial efficiency, and lifespan of the secondary battery when being applied as the negative-electrode material for the secondary battery.

Another purpose of the present disclosure is to provide a method capable of efficiently preparing a silicon-carbon composite having excellent sphericity without using a substrate, unlike a conventional preparation method, in preparing the silicon-carbon composite for a negative-electrode material of a secondary battery having excellent characteristics.

Still another purpose of the present disclosure is to provide a method for efficiently preparing a silicon-carbon composite having a crystallite size of silicon particles of 10 nm or smaller and a D₅₀ value of the silicon-carbon composite particle of 1 *µ*m to 10 *µ*m without a separate pulverizing process in preparing the silicon-carbon composite for a secondary battery negative-electrode material having excellent characteristics.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

### TECHNICAL SOLUTION

In order to achieve the above purpose, according to a first aspect of the present disclosure, a silicon-carbon composite comprising silicon particles and a carbon material may be provided,
wherein the silicon particles may be amorphous silicon particles having an average crystallite size of 10 nm or smaller,
wherein a D₅₀ value of the silicon-carbon composite may be in a range of 1 *µ*m to 10 *µ*m,
wherein a sphericity of the silicon-carbon composite may be 0.7 or greater.

The sphericity of the silicon-carbon composite may be 0.9 or greater.

A carbon-based amorphous coating layer made of a carbon-based coating material may be formed on a surface of the silicon-carbon composite.

The carbon-based coating material may include at least one selected from the group consisting of a petroleum-based pitch, ethylene, acetylene, methane, ethane, epoxy resin, polyphenol, polyaniline, polyvinyl alcohol, polyvinyl chloride, and other cross-linked polymers.

A content of the silicon particles may be in a range of 55 to 70 wt% based on a total weight of the silicon-carbon composite, wherein a content of the carbon material may be in a range of 30 to 45 wt% based on the total weight of the silicon-carbon composite.

According to a second aspect of the present disclosure, a negative-electrode material for a secondary battery may be provided, the negative-electrode material comprising the silicon-carbon composite according to the first aspect of the present disclosure.

According to a third aspect of the present disclosure, a method for preparing a silicon-carbon composite may be provided, the method comprising:
(S1) raising a temperature of a rotary furnace to a temperature of 400°C to 650°C while the rotary furnace has been purged with inert gas; and
(S2) simultaneously introducing a silicon source gas and a carbon source gas into the rotary furnace to perform a homogenous reaction under an atmospheric pressure condition such that silicon and carbon are co-deposited to obtain the silicon-carbon composite,
wherein the obtained silicon-carbon composite may include silicon particles and a carbon material,
wherein an average crystallite size of the silicon particles may be 10 nm or smaller,
wherein a D₅₀ value of the silicon-carbon composite may be in a range of 1 *µ*m to 10 *µ*m, wherein a sphericity of the silicon-carbon composite may be 0.7 or greater.

The inert gas may include at least one of nitrogen gas or argon gas.

The rotary furnace may be a chemical vapor deposition (CVD) reactor equipped with a rotary baffle.

The silicon source gas may include at least one selected from the group consisting of monosilane (SiH₄) gas, disilane (Si₂H₆) gas, monochlorosilane (SiH₃Cl) gas, dichlorosilane (SiH₂Cl₂) gas, trichlorosilane (SiHCl₃) gas, and trimethylsilane (SiH(CH₃)₃) gas.

The carbon source gas may include at least one selected from the group consisting of methane gas, ethane gas, propane gas, butane gas, ethylene gas and acetylene gas,
The sphericity of the silicon-carbon composite may be 0.9 or greater.

In the (S2), the silicon-carbon composite may be cooled to a room temperature of 15°C to 25°C to obtain solid powders of the silicon-carbon composite.

The method may further comprise, after termination of the reaction in the (S2), (S3) introducing a carbon-based source gas for a coating material and an inert gas into the rotary furnace to form a carbon-based amorphous coating layer on a resultant product obtained in the (S2), thereby obtaining a final silicon-carbon composite.

The (S3) may be performed in a chemical vapor deposition manner.

The carbon-based source gas may be one selected from the group consisting of methane gas, ethane gas, propane gas, butane gas, acetylene gas, ethylene gas, and propylene gas.

### TECHNICAL EFFECT

The present disclosure may provide the silicon-carbon composite including silicon particles having the particle size adjusted so as to be capable of preventing silicon crack and minimizing volume expansion of the silicon particle even during charging and discharging of a secondary battery, and the negative-electrode material for a secondary battery including the same.

Due to the excellent characteristics of the silicon-carbon composite of the present disclosure, the initial discharge capacity, initial efficiency, and lifetime characteristics of the secondary battery prepared so as to include the silicon-carbon composite as the negative-electrode material may be improved.

The method of the present disclosure may prepare the silicon-carbon composite through homogenous reaction without a substrate, and may efficiently prepare the silicon-carbon composite having a high sphericity of 0.7 or greater.

The present disclosure may provide the method for preparing the silicon-carbon composite having a crystallite size of silicon particles of 10 nm or smaller and a D₅₀ value of 1 *µ*m to 10 *µ*m without a separate pulverizing process.

In addition to the above-described effects, the effects of the present disclosure will be described together while describing matters for carrying out the following disclosure.

### BRIEF DESCRIPTION OF DRAWINGS

FIG. 1 is a diagram briefly showing an embodiment of a method for preparing a silicon-carbon composite of the present disclosure.
FIG. 2 is a diagram briefly illustrating another embodiment of a method for preparing a silicon-carbon composite of the present disclosure.
FIG. 3 is a SEM image of observing particles of a silicon-carbon composite in a cross section of an electrode plate of Present Example 1 of the present disclosure.
FIG. 4 is a SEM image of observing particles of a silicon-carbon composite in a cross-section of an electrode plate of Comparative Example 1 of the present disclosure.
FIG. 5 is an analysis graph for calculating a silicon crystallite size through X-ray diffraction analysis of a silicon-carbon composite obtained in Present Example 1 of the present disclosure.

### DETAILED DESCRIPTIONS

The above-described objects, features, and advantages will be described in detail with reference to the accompanying drawings, and accordingly, a person having ordinary skill in the art to which the present disclosure pertains will be able to easily implement the technical idea of the present disclosure. In the description of the present disclosure, when it is determined that a detailed description of a known technology related to the present disclosure may unnecessarily obscure the gist of the present disclosure, the detailed description will be omitted.

In the present disclosure, when "includes", "has", "is made", "is disposed", "has", or the like are used, other parts may be added unless "only" is used. The expression of a component in a singular manner includes a plurally thereof unless otherwise specified.

As used herein, "crystallite" refers to "crystal grain", and refers to "a region of a material in which atoms are aligned and arranged in a repetitive pattern".

In the present disclosure, "crystallite size" is measured through XRD (equipment name: panalytical-x'pert pro) analysis, and a crystallite size automatically derived through Scherer equation based on XRD data measured in the equipment is used.

In the present disclosure, measurement of "D₅₀ value" is performed in the particle size analyzer (PSA) manner, and the particle size is calculated based on the distribution of the scattering angle of the light scattered while the light is passing through the powder sample as the sample to be measured, and the measurement equipment was LS 13 320 Particle Size Analyzer (Beckman Coupler). In this regard, the D₅₀ value means a particle size value of the particles accounting for 50% in the order of the smallest particle size in the entire particle size distribution of the powders.

In the present disclosure, "sphericity" is obtained by analyzing the appearance image of the particles through Microscope (SEM, JSM-7100F, and OM), and defining a longitudinal axis and a transverse axis so as to intersect with each other at 90° while passing through the center of the silicon particle, and converting a ratio of the length in the transverse axis of the particle with respect to the length of the longitudinal axis of the particle into a percentage.

In the present disclosure, in interpreting a numerical value, it is interpreted as including an error range even when there is no separate explicit description.

### Hereinafter, the present disclosure will be described in more detail.

### Silicon-carbon composite

The silicon-carbon composite of the present disclosure is a silicon-carbon composite comprising silicon particles and a carbon material, wherein the silicon particles may be amorphous silicon particles having an average crystallite size of 10 nm or smaller, and the average particle diameter of the silicon-carbon composite may be in a range of 1 *µ*m to 10 *µ*m, the sphericity thereof may be 0.7 or greater, preferably the sphericity thereof may be 0.8 or greater, and most preferably the sphericity thereof may be 0.9 or greater

It is preferable that the D₅₀ value of the silicon-carbon composite of the present disclosure is in the range of 1 *µ*m to 10 *µ*m. When the D₅₀ value exceeds 10 *µ*m, a separate process in which the particle size needs to be adjusted through an additional spheroidization process or a pulverizing process may be required. When a separate pulverizing process is performed, process inefficiency may occur and the purity of silicon particles may be lowered due to the introduction of impurities in the pulverizing process.

In addition, when the value of D₅₀ of the silicon-carbon composite is smaller than 1 *µ*m, the silicon-carbon composite particles may not be uniformly mixed or dispersed when preparing the negative-electrode material slurry due to low stability and dispersibility. Thus, performance of the secondary battery may be deteriorated when the silicon-carbon composite is applied as the negative-electrode material of the secondary battery.

The silicon particles included in the silicon-carbon composite of the present disclosure may be amorphous silicon particles having an average crystal size of 10 nm or smaller, preferably 1 to 5 nm, and more preferably 1 to 3 nm.

If the average crystallite size of the silicon particles exceeds 10 nm, there may be a problem in that the lifespan is deteriorated during the charge/discharge cycle of the secondary battery when the silicon-carbon composite is applied as a negative-electrode material of the secondary battery, and thus, it is preferable to control the average crystallite size of the silicon particles to 10 nm or smaller.

The silicon-carbon composite of the present disclosure has a sphericity of 0.7 or greater, preferably 0.8 or greater, and most preferably 0.9 or greater. When the aspherical silicon-carbon composite is used as a negative-electrode material for a secondary battery, dispersibility is lowered, and there is a high probability of generating a side reaction in the charging/discharging process of the secondary battery, and consequently, the performance of the secondary battery is deteriorated. In addition, when the sphericity thereof is smaller than 0.7, the surface area per the same mass is increased, and thus there may be a disadvantage in that an unstable SEI layer (Solid Electrolyte Interphase Layer) is formed.

The silicon-carbon composite of the present disclosure may be formed via co-deposition without a separate substrate. This may be advantageous in achieving the high sphericity of the silicon-carbon composite because there is no separate pulverizing process.

According to an embodiment of the present disclosure, the carbon-based amorphous coating layer made of a carbon-based coating material may be formed on a surface of the silicon-carbon composite, if necessary. When the coating layer is formed as described above, the silicon exposed to the outside out of the silicon-carbon composite may be more effectively protected, the particle strength of the silicon-carbon composite may be improved, and the electrical conductivity may be increased, thereby achieving the physical properties required for the silicon-carbon composite.

According to an embodiment of the present disclosure, the carbon-based coating material constituting the carbon-based amorphous coating layer may include, for example, at least one selected from the group consisting of petroleum-based pitch, ethylene, acetylene, methane, ethane, epoxy resin, polyphenol, polyaniline, polyvinyl alcohol, polyvinyl chloride, and other cross-linked polymers.

A thickness of the coating layer may be adjusted in accordance with the size of the silicon-carbon composite. The thickness thereof may be, un a range of, for example, about 1 nm to 50 nm, for example, about 1 nm to 30 nm, for example, about 1 nm to 20 nm, for example, about 1 nm to 10 nm, for example, about 1 nm to 5 nm. However, the present disclosure is not necessarily limited thereto.

### Method of Preparing Silicon-Carbon Composite

The present disclosure proposes a method for preparing a silicon-carbon composite without a substrate, unlike conventional techniques, wherein the prepared silicon-carbon composite may satisfy the characteristics of the silicon-carbon composite of the present disclosure as described above.

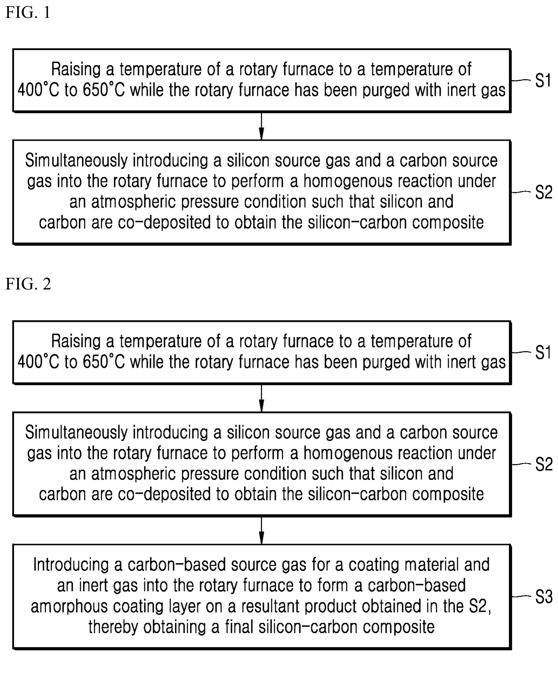

Referring to FIG. 1, the method for preparing the silicon-carbon composite according to the present disclosure may include following steps (S1) and (S2).
(S1) raising a temperature of a rotary furnace to a temperature of 400°C to 650°C while the rotary furnace has been purged with inert gas; and
(S2) simultaneously introducing a silicon source gas and a carbon source gas into the rotary furnace to perform a homogenous reaction under an atmospheric pressure condition such that silicon and carbon are co-deposited to obtain the silicon-carbon composite.

The silicon-carbon composite obtained by the preparation method comprises silicon particles and a carbon material, wherein the average crystallite size of the silicon particles may be 10 nm or smaller, the D₅₀ value of the silicon-carbon composite may be in a range of 1 *µ*m to 10 *µ*m, the and sphericity thereof may be 0.7 or greater, preferably 0.8 or greater, and more preferably 0.9 or greater.

As described above, during the homogeneous reaction, the silicon-carbon composite may be formed via homogeneous reaction deposition (co-precipitation) of the silicon and carbon source gases, and the silicon-carbon composite may be grown due to turbulence generated in the reaction apparatus.

In addition, in accordance with the present disclosure, the rotary furnace in the (S1) may be a chemical vapor deposition (CVD) reactor which may be embodied as the rotary chemical vapor deposition reactor with a baffle added thereto for uniform reactivity and prevention of aggregation, thereby appropriately controlling the flow rate of each of the silicon source gas and the carbon source gas and a rotational speed of the furnace to control the final particle size D₅₀ of the silicon-carbon composite generated via the homogeneous reaction and the sphericity of the silicon-carbon composite. When the ideal particle size and sphericity are obtained, the silicon-carbon composite may be immediately used as the negative-electrode material without any additional process.

In the (S1), the rotary furnace is sufficiently purged with the inert gas, and then may be heated until the temperature thereof reaches a target temperature of 400°C to 650°C at a temperature increase rate of, for example, 15°C/min. The purging of the furnace with the inert gas as described above is to control the overall reaction rate and to obtain a uniform homogeneous reaction product, and the inert gas may include at least one of nitrogen gas or argon gas. However, the present disclosure is not necessarily limited thereto.

The temperature condition under which the homogeneous reaction is performed in the (S1) and may be in a range of, for example, 400°C to 650°C, and may be in a range of, for example, 420°C to 500°C.

When the temperature of the furnace has reached the target temperature in the (S1), the silicon source gas and the carbon source gas may be simultaneously introduced into the furnace at a flow rate of 100 mℓ/min to 200 mℓ/min and a flow rate of 10 mℓ/min to 30 mQ/min, respectively, and the homogeneous reaction may be performed for 30 mins to 3 hours under an atmospheric pressure condition in the (S2). For example, the silicon source gas may be introduced thereto at a flow rate of 125 mQ/min and the carbon source gas may be introduced thereto at a flow rate of 25 mℓ/min. However, the present disclosure is not limited thereto.

According to an embodiment of the present disclosure, the silicon source gas may include at least one selected from the group consisting of monosilane (SiH₄) gas, disilane (Si₂H₆) gas, monochlorosilane (SiH₃Cl) gas, dichlorosilane (SiH₂Cl₂) gas, trichlorosilane (SiHCl₃) gas, and trimethylsilane (SiH(CH₃)₃) gas. However, the present disclosure is not necessarily limited thereto.

According to an embodiment of the present disclosure, the carbon source gas may include at least one selected from the group consisting of methane gas, ethane gas, propane gas, butane gas, ethylene gas, and acetylene gas. However, the present disclosure is not necessarily limited thereto.

After the homogeneous reaction has been terminated in the (S2), the silicon-carbon composite may be cooled to the room temperature of 15°C to 25°C to obtain solid powders of the silicon-carbon composite. Thus, the particles of the grown silicon-carbon composite are collected. In this collecting step, a scheme of flowing a fluid such as air as a medium may be used. For example, a bag filter may be used to collect the particles of the silicon-carbon composite.

Referring to FIG. 2 according to an embodiment of the present disclosure, the method may further comprise, after the (S2), (S3) introducing a carbon-based source gas for a coating material and an inert gas into the rotary furnace to form a carbon-based amorphous coating layer on a resultant product obtained in the (S2), thereby obtaining a final silicon-carbon composite.

For example, while the carbon-based source gas for a coating material and the inert gas are injected into the furnace at a flow rate of 20 mℓ/min to 80 mℓ/min and a flow rate of 300 mℓ/min to 600 mℓ/min, respectively, the reaction may occur for 10 minutes to 2 hours. For example, while the carbon-based source gas for the coating material and the inert gas are injected thereto at a flow rate of 50 mℓ/min and a flow rate of 450 mℓ/min, respectively, the reaction may occur for 30 minutes. However, the present disclosure is not limited thereto.

The description of the carbon-based amorphous coating layer is the same as the description of the coating layer made of the carbon-based coating material formed on the surface of the silicon-carbon composite of the present disclosure.

In this case, the carbon-based source gas for forming the carbon-based coating layer may be the same as or different from the carbon source gas used in the (S2), and may be, for example, one selected from the group consisting of methane gas, ethane gas, propane gas, butane gas, acetylene gas, ethylene gas, and propylene gas.

According to an embodiment of the present disclosure, the (S3) may be performed in an chemical vapor deposition (CVD) manner. However, the present disclosure is not necessarily limited thereto.

### EXAMPLES

Hereinafter, the present disclosure will be described in more detail with reference to Present Examples. However, the following Present Examples are merely to describe the present disclosure by way of example, and the contents of the present disclosure are not limited to the following Present Examples.

### [Preparation Example]

### Present Example 1

The rotary furnace sufficiently purged with argon (Ar) gas was heated to 450°C at a temperature-raising rate of 15°C/min, and then monosilane gas (SiH₄) and ethylene (C₂H₄) gas were simultaneously introduced thereto at a flow rate of 125 mℓ/min and a flow rate of 25 mℓ/min, respectively, while maintaining the rotational speed of the furnace as the reactor at 1.0 rpm. The reaction occurred for 2 hours under the atmospheric pressure condition. Thus, the silicon-carbon composite was prepared. Then, ethylene (C₂H₄) gas was the carbon source gas for the coating material and argon (Ar) gas were injected thereto at a flow rate of 50 mℓ/min and a flow rate of 450 mQ/min, respectively, at the same temperature, and the reaction additionally occurred for 30 minutes. Thus, the carbon-based amorphous coating layer was formed on the surface of the silicon-carbon composite. After the above reaction had been completed, the inside of the furnace was replaced with argon and the silicon-carbon composite was cooled to room temperature to obtain a final silicon-carbon composite.

### Comparative Example 1

The rotary furnace sufficiently purged with argon (Ar) gas was heated to 450°C at a temperature increase rate of 15°C/min, and then, monosilane (SiH₄) gas and ethylene (C₂H₄) gas were simultaneously introduced into the furnace at a flow rate of 125 mℓ/min and a flow rate of 25 mℓ/min, respectively so as to be directed onto a graphite plate as the substrate plate for deposition. The reaction was performed for 2 hours under the atmospheric pressure condition to obtain a silicon-carbon composite mass deposited on the substrate plate in a wide manner. After the reaction was completed, the inside of the rotary furnace was replaced with argon gas and the furnace was cooled to the room temperature. Then, the silicon-carbon composite mass was collected. The silicon-carbon composite mass was processed to have a particle size similar to that of Present Example 1 through a pulverizing process.

5g of the pulverized silicon-carbon composite particles was introduced into the rotary furnace and the furnace was heated to 450°C at a temperature-raising rate of 15°C/min, and then, ethylene (C₂H₄) gas and argon (Ar) gas were introduced to the furnace at a flow rate of 50 mℓ/min and a flow rate of 450 mQ/min, respectively, and the reaction additionally occurred for 30 minutes, thereby forming a carbon coating layer on the surface of the silicon-carbon composite.

After the above reaction had been completed, the inside of the furnace was replaced with argon and the furnace was cooled to the room temperature to obtain a final silicon-carbon composite.

### Comparative Example 2

The same process as that in Present Example 1 was performed except that the flow rates of monosilane gas (SiH₄) and ethylene (C₂H₄) gas were controlled to 75 mℓ/min and 75 mℓ/min, respectively.

### [Experimental Example]

### Measurement of characteristics of particles

The D₅₀, crystallite size, and sphericity of the silicon-carbon composite prepared in each of Present Example 1, Comparative Example 1, and Comparative Example 2 were measured and shown in a following Table 1.

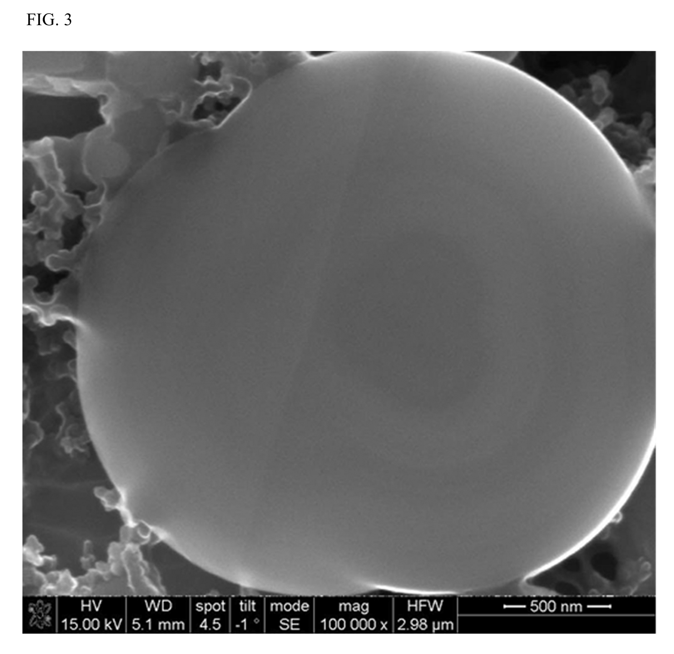

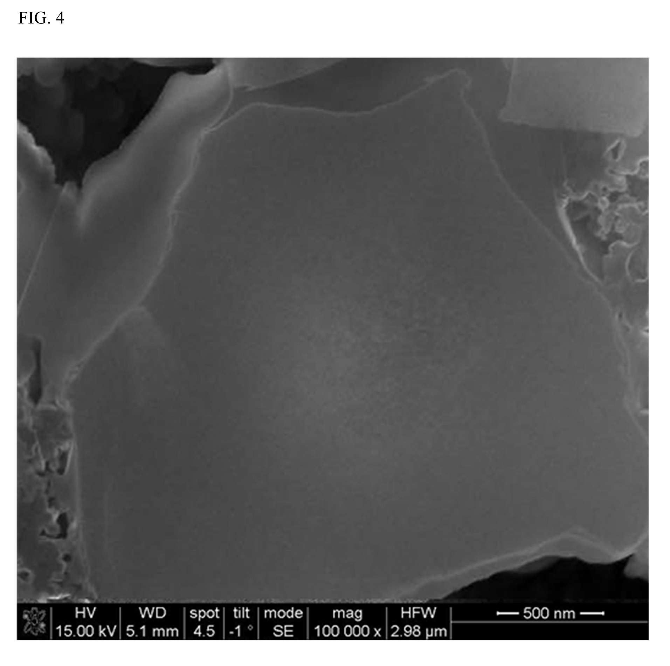

Cross-sectional SEM images of silicon-carbon particles of the silicon-carbon composites as prepared in Present Example 1 and Comparative Example 1 are shown in FIGS. 3 and 4, respectively.

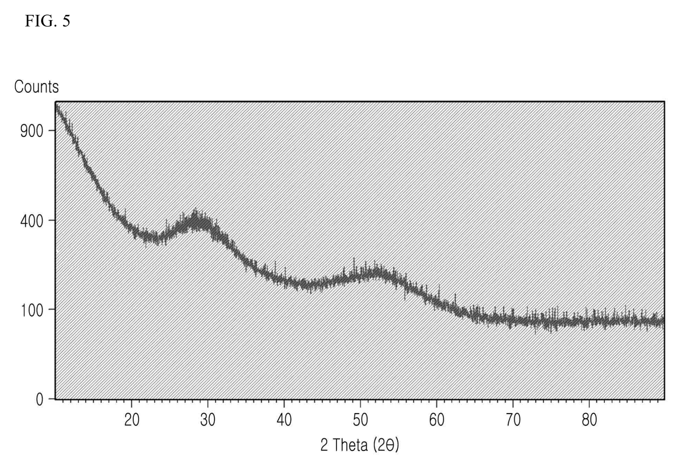

A graph of XRD analysis of the silicon-carbon composite of Present Example 1 is shown in FIG. 5.

The crystallite size of silicon is determined by observing a peak at a point where 2θ(theta) [unit: degree(°)] is 28° in the XRD analysis graph. In addition, when there is no peak in the XRD analysis graph, a type of the measurement target is determined as an amorphous type. When the peak is distributed in a broad manner, a type of the measurement target is interpreted as a mixture of an amorphous type and a crystalline type.

Referring to FIG. 5, since the silicon-carbon composite prepared in Present Example 1 corresponds to a case in which a peak at a point where 2θ is 28° is distributed in the broad manner, it may be determined that the silicon particles are present in a mixture of the amorphous silicon particles and crystalline silicon particles. The average crystallite size of crystalline silicon particles calculated using the XRD analysis data, and according to [Highscore plus] as a program in the XRD analysis equipment and based on the Scherrer equation was 1.6 nm.

The vertical axis "count" of FIG. 5 refers to a signal entering a detector after an X-ray is incident on a sample, and corresponds to the intensity of the general XRD analysis data.

"Copper(Cu)" as a horizontal axis of FIG. 5 refers to a source that generates X-ray radiation, and specifically refers to "XRD(X-ray diffraction) pattern obtained with Cu-K α radiation".

### Negative-electrode slurry preparation

The silicon-carbon composite prepared in the Preparation Example and artificial graphite (average particle diameter=14 µm) were mixed with each other at a weight ratio of 20:80 to prepare a negative-electrode material.

The prepared negative-electrode material, a conductive material (Super P: SWCNT=9: 1, weight ratio) and a binder (CMC: SBR=3: 7, weight ratio) were mixed with each other in a weight ratio of negative-electrode material: conductive material: binder=80: 10: 10 using a Thinky-Mixer to obtain a negative-electrode slurry.

### Cell test

The negative-electrode slurry was coated on a copper foil having a thickness of 18 *µ*m, dried in an oven of 80°C for 1 hour, and then heat-treated in a vacuum oven of 100°C for 12 hours to prepare a negative-electrode plate. Punching was performed thereon so as to have 16mmØ. The punched plate portion was combined with Li metal as a counter electrode such that a coin cell was manufactured. Then, the electrochemical characteristics thereof was checked.

The charging and discharging conditions were charging CC/CV: 0.005V/0.005C, discharging CC 1.5 V, and a rate of 0.1 C was used. The initial discharge capacity (IDC) and initial efficiency (ICE) were measured using TOSCAT-3100 equipment as a half-cell apparatus and are shown in Table 1 as set forth below.

**[Table 1]**

| | D₅₀ (*µ*m) | Si crystallite size (nm) | Sphericity | Initial discharge capacity (mAh/g) | Initial efficiency (%) |
|---|---|---|---|---|---|
| Present Example 1 | 5.42 | 1.6 | 0.914 | 545 | 89.0 |
| Comparative Example 1 | 5.19 | 1.6 | 0.665 | 548 | 83.3 |
| Comparative Example 2 | 0.42 | 1.6 | 0.927 | 547 | 56.9 |

As shown in the above Table 1, in Present Example 1, the silicon-carbon composite was prepared via the co-deposition without the substrate, and thus a high sphericity of 0.914 could be achieved, and this was identified based on a smooth spherical particle surface observed in the SEM image of FIG. 3.

On the contrary, in Comparative Example 1, the silicon-carbon composite was prepared by performing the deposition using the substrate and performing the pulverization process. Thus, it may be identified that the sphericity is very low at 0.665. In this regard, it may be identified with the naked eye that the surface of the particles is uneven in the SEM image of FIG. 4.

The silicon-carbon composite of Comparative Example 2 did not satisfy that the D₅₀ of the silicon-carbon composite was 1 *µ*m or greater as defined in the present disclosure, and accordingly, it was difficult to prepare a uniform slurry because the composite particles were not well dispersed during the slurry preparation, and as a result, the initial efficiency was very low in the coin cell test.

The present disclosure is not necessarily limited to such an embodiment, and may be variously modified within a range not departing from the technical idea of the present disclosure. Therefore, the embodiments disclosed herein are not for limiting the technical idea of the present disclosure, but for specifically describing the technical idea of the present disclosure, and the scope of the technical idea of the present disclosure is not limited by such embodiments. Therefore, it should be understood that the embodiments described above are exemplary in all respects and are not limited. The scope of protection of the present disclosure should be interpreted by the claims, and all technical ideas within the scope equivalent thereto should be interpreted as being included in the scope of the rights of the present disclosure.

## Claims

1. A silicon-carbon composite comprising silicon particles and a carbon material,
wherein the silicon particles are amorphous silicon particles having an average crystallite size of 10 nm or smaller,
wherein a sphericity of the silicon-carbon composite is 0.7 or greater.

2. The silicon-carbon composite of claim 1, wherein the sphericity of the silicon-carbon composite is 0.9 or greater.

3. The silicon-carbon composite of claim 1, wherein a carbon-based amorphous coating layer made of a carbon-based coating material is formed on a surface of the silicon-carbon composite.

4. The silicon-carbon composite of claim 1, wherein the carbon-based coating material includes at least one selected from the group consisting of a petroleum-based pitch, ethylene, acetylene, methane, ethane, epoxy resin, polyphenol, polyaniline, polyvinyl alcohol, polyvinyl chloride, and other cross-linked polymers.

5. The silicon-carbon composite of claim 1, wherein a content of the silicon particles is in a range of 55 to 70 wt% based on a total weight of the silicon-carbon composite,
wherein a content of the carbon material is in a range of 30 to 45 wt% based on the total weight of the silicon-carbon composite.

6. A negative-electrode material for a secondary battery, the negative-electrode material comprising the silicon-carbon composite according to one of claims 1 to 5.

7. A method for preparing a silicon-carbon composite, the method comprising:
(S1) raising a temperature of a rotary furnace to a temperature of 400°C to 650°C while the rotary furnace has been purged with inert gas; and
(S2) simultaneously introducing a silicon source gas and a carbon source gas into the rotary furnace to perform a homogenous reaction under an atmospheric pressure condition such that silicon and carbon are co-deposited to obtain the silicon-carbon composite,
wherein the obtained silicon-carbon composite includes silicon particles and a carbon material,
wherein an average crystallite size of the silicon particles is 10 nm or smaller,
wherein a D₅₀ value of the silicon-carbon composite is in a range of 1 *µ*m to 10 *µ*m,
wherein a sphericity of the silicon-carbon composite is 0.7 or greater.

8. The method for preparing the silicon-carbon composite of claim 7, wherein the inert gas includes at least one of nitrogen gas or argon gas.

9. The method for preparing the silicon-carbon composite of claim 7, wherein the rotary furnace is a chemical vapor deposition (CVD) reactor equipped with a rotary baffle.

10. The method for preparing the silicon-carbon composite of claim 7, wherein the silicon source gas includes at least one selected from the group consisting of monosilane (SiH₄) gas, disilane (Si₂H₆) gas, monochlorosilane (SiH₃Cl) gas, dichlorosilane (SiH₂Cl₂) gas, trichlorosilane (SiHCl₃) gas, and trimethylsilane (SiH(CH₃)₃) gas.

11. The method for preparing the silicon-carbon composite of claim 7, wherein the carbon source gas includes at least one selected from the group consisting of methane gas, ethane gas, propane gas, butane gas, ethylene gas and acetylene gas,

12. The method for preparing the silicon-carbon composite of claim 7, wherein the sphericity of the silicon-carbon composite is 0.9 or greater.

13. The method for preparing the silicon-carbon composite of claim 7, wherein in the (S2), the silicon-carbon composite is cooled to a room temperature of 15°C to 25°C to obtain solid powders of the silicon-carbon composite.

14. The method for preparing the silicon-carbon composite of claim 7, wherein the method further comprises, after termination of the reaction in the (S2), (S3) introducing a carbon-based source gas for a coating material and an inert gas into the rotary furnace to form a carbon-based amorphous coating layer on a resultant product obtained in the (S2), thereby obtaining a final silicon-carbon composite.

15. The method for preparing the silicon-carbon composite of claim 14, wherein the (S3) is performed in a chemical vapor deposition manner.

16. The method for preparing the silicon-carbon composite of claim 14, wherein the carbon-based source gas is one selected from the group consisting of methane gas, ethane gas, propane gas, butane gas, acetylene gas, ethylene gas, and propylene gas.
